# EUROPÄISCHE PATENTSCHRIFT

(11) **EP 0 652 594 B1**
(45) Veröffentlichungstag und Bekanntmachung des Hinweises auf die Patenterteilung: **02.01.2004**
(21) Anmeldenummer: 94117038.3
(22) Anmeldetag: 27.10.1994
(51) Int. Cl.: H01L 27/06, H01L 29/78, H01L 29/74

(54) **Integrierte Schaltungsanordnung mit Leistungsbauelement und Niederspannungsbauelementen**
Integrated circuit with power element and low voltage elements
Circuit intégré avec élément de puissance et éléments à basse tension

(30) Priorität: 05.11.1993 DE 4337873
(43) Veröffentlichungstag der Anmeldung: 10.05.1995
(73) Patentinhaber: Infineon Technologies AG, 81669 München (DE)
(72) Erfinder: Schwalke, Udo, Dr., D-84431 Heldenstein (DE); Stoisiek, Michael, Dr., D-85521 Ottobrun (DE)
(74) Vertreter: Patentanwälte Westphal, Mussgnug & Partner

(56) Entgegenhaltungen:
- US-A- 5 051 808
- INTERNATIONAL ELECTRON DEVICES MEETING 1987, Dezember 1987, WASHINGTON, D.C. U.S.A. Seiten 460 - 463 KAZUMASA KIOI ET AL. 'SOI PHOTODIODE ARRAY STACKED ON VDMOS FOR OPTICAL SWITCHING'
- PATENT ABSTRACTS OF JAPAN vol. 16, no. 360 (E-1243) 4. August 1992 & JP-A-04 113 679 (NISSAN MOTOR CO LTD) 15. April 1992
- PATENT ABSTRACTS OF JAPAN vol. 17, no. 152 (E-1340) 25. März 1993 & JP-A-04 318 972 (KAWASAKI STEEL CORP) 10. November 1992
- IEEE ELECTRON DEVICE LETTERS., Bd.13, Nr.10, Oktober 1992, NEW YORK US Seiten 516 - 518 GARY M. DOLNY ET AL. 'Silicon-on-Insulator Approach for Power IC's Integrating Vertical DMOS and Polycrystalline-Silicon CMOS Thin-Film Transistors'
- PATENT ABSTRACTS OF JAPAN vol. 7, no. 190 (E-194) (1335) 19. August 1983 & JP-A-58 092 254 (MITSUBISHI DENKI K.K.) 1. Juni 1983
- PATENT ABSTRACTS OF JAPAN vol. 12, no. 418 (E-678) (3265) 7. November 1988 & JP-A-63 155 653 (MATSUSHITA ELECTRONICS CORP) 28. Juni 1988
- PATENT ABSTRACTS OF JAPAN vol. 15, no. 147 (E-1055) 12. April 1991 & JP-A-03 022 432 (NEC CORP) 30. Januar 1991

## Beschreibung

Unter Smart-Power-IC's werden integrierte Schaltungsanordnungen verstanden, die eine Kombination aus Leistungs-IC's und einem "intelligenten Teil", der Logikbausteine oder Sensorbausteine oder ähnliches umfaßt, verstanden. Während die Leistungs-IC's meist mit höheren Spannungen über 100 Volt, in der Regel um 500 Volt, betrieben werden, umfaßt der intelligente Teil Niederspannungsbauelemente, die bei Spannungspegeln um 5 Volt betrieben werden. Es ist daher erforderlich, die Leistungs-IC's von den Niederspannungsbauelementen elektrisch zu trennen. Als Leistungs-IC's werden zum Beispiel MOSFET's, IGBT's (Insulated Gate Bipolar Transistor), MCT (MOS controlled Thyristor) und ähnliche verwendet.

Die Isolation zwischen Leistungs-IC's und den Niederspannungsbauelementen soll Störungen im intelligenten Teil durch elektrische Felder und/oder Minoritätsträger-Injektion vermeiden, möglichst verhindern. Diese Isolation wird vielfach als dielektrische Isolation realisiert.

Aus I. Nakagawa ISPSD 91 p. 16 ist zu diesem Zweck die dielektrische Isolation auf einem SOI-Substrat, das nach dem DWB-(direct wafer bonding) oder SDB-(Silicon wafer direct bonding)-Verfahren hergestellt ist, bekannt. Dabei werden in der Siliziumschicht des SOI-Substrates die Bauelemente realisiert. Die einzelnen Bauelemente werden gegeneinander durch einen das jeweilige Bauelement vollständig umgebenden isolierenden Graben, der bis auf die isolierende Schicht des SOI-Substrats reicht, isoliert. Sowohl Leistungsbauelemente als auch Niederspannungsbauelemente werden nebeneinander in der Siliziumschicht des SOI-Substrats realisiert.

Damit setzt sich die Bauelementfläche additiv aus der vom Leistungsbauelement und vom intelligenten Teil jeweils für sich beanspruchten Fläche zusammen. Außerdem besteht die Gefahr einer Störung des intelligenten Teils durch kapazitive Einflüsse.

Aus B. Mütterlein et al. Proc. ESSDERC 93 S. 879 bis 882 ist bekannt, Leistungsbauelemente und Niederspannungsbauelemente in einem Substrat zu integrieren, wobei zur Isolation zwischen den Leistungsbauelementen und den Niederspannungsbauelementen lokal im Bereich der Niederspannungsbauelemente Sauerstoff implantiert wird, so daß ein SIMOX-Substrat entsteht. Auch bei dieser Technik ist der Flächenbedarf der resultierenden Schaltung gleich der Summe der Flächen der Teilschaltungen. Kapazitive Störungen auf die Niederspannungsbauelemente wirken sich hier noch stärker aus.

Aus Cahill et al, ECS 89, p. 324 (1989) ist bekannt, Leistungsbauelemente in einem Siliziumsubstrat zu realisieren. Benachbarte Leistungsbauelemente werden durch Feldoxidbereiche, die zum Beispiel in einem LOCOS-Prozeß hergestellt sind, gegeneinander isoliert. Anschließend wird die Oberfläche des Substrats mit einer isolierenden Schicht versehen. Auf der isolierenden Schicht wird eine Polysiliziumschicht aufgebracht, die durch Zonenschmelzen rekristallisiert wird. In der rekristallisierten Siliziumschicht werden Dünnfilm-MOS-Transistoren realisiert. Die Dünnfilm-MOS-Transistoren werden oberhalb der Feldoxidbereiche zwischen den Leistungsbauelementen angeordnet. Auch hier setzt sich der Flächenbedarf aus der Fläche für den intelligenten Teil und der Fläche für den Leistungsteil zusammen.

Aus F. Robb et al. ECS 92 Conference Proc. p467 und G. M. Dolny et al IEDM 92 Conf. Proc. p233 ist bekannt, Leistungsbauelemente in einem Siliziumsubstrat zu integrieren und für den intelligenten Teil MOS-Dünnfilmtransistoren in einer polykristallinen Siliziumschicht zu realisieren. Die Polysiliziumschicht wird oberhalb von Isolationsbereichen angeordnet, die die Leistungsbauelemente im Substrat trennen. Die Dünnfilmtransistoren werden dann oberhalb dieser Isolationsbereiche angeordnet. Es ist insbesondere möglich, die Dünnfilmtransistoren in derselben Polysiliziumschicht zu realisieren, aus der die Gateelektroden für die Leistungsbauelemente hergestellt sind. Die Flächen für die Leistungsbauelemente und die Fläche für den intelligenten Teil bestimmen als Summe die Fläche des Bauelementes.

Aus Nakashima et al., Electronics Lett. 19, p.1095 (1983) ist bekannt Hochspannungs-CMOS-Transistoren mit vergrabenem Kanal in einem SIMOX-Substrat herzustellen. Dazu wird durch Implantation von Sauerstoff eine vergrabene SiO₂-Schicht gebildet. In demselben Implantationsschritt wird durch Steuerung des Teilchenstroms während der Implantation zwischen der SiO₂-Schicht und dem Transistorgebiet eine das elektrische Feld abschirmende Schicht (electric field shielding layer) gebildet.

Aus IEDM-87, Seiten 460 bis 463, ist eine Photodiodenanordnung bekannt, die in einer SOI-Schicht oberhalb eines Leistungs-MOS-FET realisiert ist.

Aus JP-A-4113679 ist eine Schutzschaltung bekannt, bei der ein Leistungs-MOS-FET und ein Schalt-MOS-FET übereinander angeordnet sind. Dabei ist die Gateelektrode sowohl für den Leistungs-MOS-FET als auch für den Schalt-MOS-FET identisch. Die aktiven Teile des Schalt-MOS-FET sind in einer rekristallisierten SOI-Schicht angeordnet.

Aus JP-A-5892254 sowie JP-A-63155653 sind dreidimensionale Schaltungsanordnungen bekannt, bei denen in gedünnten Substraten angeordnete Schaltelemente übereinander angeordnet sind. Dabei wird in JP-A-63155653 eine metallische Abschirmschicht zwischen den beiden Substraten vorgesehen, die keine Verbindung zu den Kontakten der Bauelemente aufweist.

Aus JP-A-3022432 ist eine Schaltungsanordnung bekannt, bei der oberhalb einer ersten Metallisierungsebene planarisierende isolierende Schichten vorgesehen sind, an deren Oberfläche eine zweite Metallisierungsebene realisiert wird.

Der Erfindung liegt die Aufgabe zugrunde, eine Schaltungsanordnung mit mindestens einem Leistungsbauelement und Niederspannungsbauelementen anzugeben, bei der der Platzbedarf reduziert ist und bei der dennoch Störungen der Niederspannungsbauelemente durch die Leistungsbauelemente vermieden werden.

Diese Aufgabe wird erfindungsgemäß gelöst durch eine Schaltungsanordnung nach Anspruch 1. Weitere Ausgestaltungen der Erfindung gehen aus den übrigen Ansprüchen hervor.

In der erfindungsgemäßen Schaltungsanordnung werden Dünnfilmbauelemente als Niederspannungsbauelemente eingesetzt. Es werden aktive und/oder passive Dünnfilmbauelemente realisiert wie insbesondere Dünnfilmtransistoren oder Dünnfilmkondensatoren. Die Dünnfilmbauelemente werden aus amorphem oder polykristallinem Halbleitermaterial, insbesondere Silizium, hergestellt. Vorzugsweise werden die Dünnfilmtransistoren aus polykristallinem Silizium gebildet, da dann durch entsprechende thermische und/oder Plasmabehandlung der polykristallinen Schicht Stromergiebigkeit und Sperrfähigkeit deutlich verbessert werden können (siehe zum Beispiel H. N. Chern et al. EDL Bd. 14, S. 115).

In einem Halbleitersubstrat insbesondere aus Silizium ist mindestens ein Leistungsbauelement integriert mit mindestens einem Kontakt, der auf einer Hauptfläche des Substrats angeordnet ist. Der Kontakt ist mit einer Isolationsschicht bedeckt. Oberhalb des Kontaktes ist mindestens ein Dünnfilmbauelement realisiert. Das Dünnfilmbauelement ist von dem Kontakt durch die Isolationsschicht isoliert. Der Kontakt schirmt das Dünnfilmbauelement gegen im Substrat auftretende elektrische Felder ab. Das Dünnfilmbauelement ist dabei so oberhalb des Kontaktes angeordnet, daß die Projektion der Fläche des Dünnfilmbauelementes auf den Kontakt trifft.

Im Betrieb der integrierten Schaltungsanordnung wird der Kontakt so verschaltet, daß er keinen oder nur sehr geringen Spannungsvariationen unterworfen ist. Dadurch schirmt der Kontakt das Dünnfilmbauelement gegen das Substrat wirksam ab. Dieses ist der Fall, wenn das Leistungsbauelement ein MOS-gesteuertes Bauelement mit einem Sourcebereich ist und der Kontakt die Sourceelektrode bildet. Auch die Kathode eines Leistungsbauelementes ist im Betrieb im wesentlichen keinen Spannungsvariationen unterworfen.

Da in der erfindungsgemäßen Schaltungsanordnung die Dünnfilmbauelemente oberhalb des Leistungsbauelementes angeordnet sind, benötigen sie keine zusätzliche Fläche. Leistungsbauelemente weisen eine sehr große nutzbare Oberfläche von typisch 0,5 bis 4 cm² auf, so daß auch aufwendige Dünnfilmschaltungen auf dieser Fläche realisierbar sind. Aufwendige Dünnfilmschaltungen werden zum Beispiel erforderlich, wenn sehr komplexe Logikfunktionen integriert werden sollen, wenn zur Ansteuerung hohe Ströme gefordert sind, wie es bei schnellen Schaltern der Fall ist oder wenn die Stromergiebigkeit wegen der Kristallqualität reduziert ist.

Leistungsbauelemente sind häufig in Form einer Zellenstruktur realisiert. Im Fall eines MOS-gesteuerten Leistungsbauelementes mit Sourcegebiet sind dabei eine Vielzahl von Sourcegebieten regelmäßig so angeordnet, daß sie an eine Hauptfläche eines Substrats angrenzen. Ferner sind die Sourcegebiete eingebettet in dotierte Bereiche, die jeweils einen Kanalbereich umfassen. Oberhalb des Kanalbereichs ist an der Hauptfläche des Substrats ein Gatedielektrikum und darauf eine Gateelektrode angeordnet. Die dotierten Bereiche, die die Kanalbereiche umfassen, sind ihrerseits in einen entgegengesetzt dotierten Driftbereich eingebettet, der die Spannungsfestigkeit des Bauelementes bestimmt. Der Driftbereich grenzt an der dem Sourcegebiet abgewandten Seite an ein höher dotiertes Gebiet, ein Draingebiet bei einem Leistungs-MOS-Fet oder ein Emittergebiet bei einem IGBT, an, welches von der der Hauptfläche abgewandten Oberfläche des Substrats her oder über eine vergrabene Schicht seitlich der Drainstruktur kontaktiert wird. Die miteinander verbundenen Gateelektroden auf der Hauptfläche des Substrats sind vollständig mit einer isolierenden Schicht bedeckt, auf der eine Sourcemetallisierung angeordnet ist. Die Sourcemetallisierung ist eine Verbindungsebene, die Kontakte zum Sourcegebiet im Substrat umfaßt. In der integrierten Schaltungsanordnung wird die Isolationsschicht im Fall eines solchen MOS-gesteuerten Leistungsbauelementes mit Zellenstruktur ganzflächig auf die Sourcemetallisierung aufgebracht. Die Sourcemetallisierung dient dann als Abschirmschicht gegen elektrische Felder, die durch das Leistungsbauelement bedingt werden.

Die Temperaturbelastung bei der Herstellung von Dünnfilmbauelementen ist so gering, daß der Grundprozeß des Leistungsbauelementes im wesentlichen unverändert bleibt. Lediglich die Sourcemetallisierung muß so gewählt werden, daß sie der Temperaturbelastung standhält. Zur Herstellung der erfindungsgemäßen Schaltungsstruktur finden nur Standardverfahren der CMOS-Technologie Anwendung.

Es ist besonders vorteilhaft, die Isolationsschicht mit einer planaren Oberfläche vorzusehen, da dann die Herstellung für Dünnfilmbauelemente erleichtert wird. Die planare Oberfläche der Isolationsschicht wird vorzugsweise durch ein elektrochemisches Polierverfahren hergestellt.

Im folgenden wird die Erfindung anhand eines Ausführungsbeispiels sowie eines Verfahrens zu dessen Herstellung und der Figuren näher erläutert.
- Figur 1: zeigt eine Schaltungsanordnung mit einem Dünnfilmtransistor, der oberhalb der Source-Metallisierung eines Leistungs-MOSFET's angeordnet ist.
- Figur 2: zeigt ein Substrat mit einem Leistungs-MOS-Fet nach der Herstellung der vergrabenen Gateelektrodenebene.
- Figur 3: zeigt das Substrat mit dem Leistungs-MOS-Fet nach der Herstellung der Source-Metallisierung.
- Figur 4: zeigt das Substrat mit dem Leistungs-MOS-Fet nach Herstellung einer Isolationsschicht mit planarer Oberfläche.

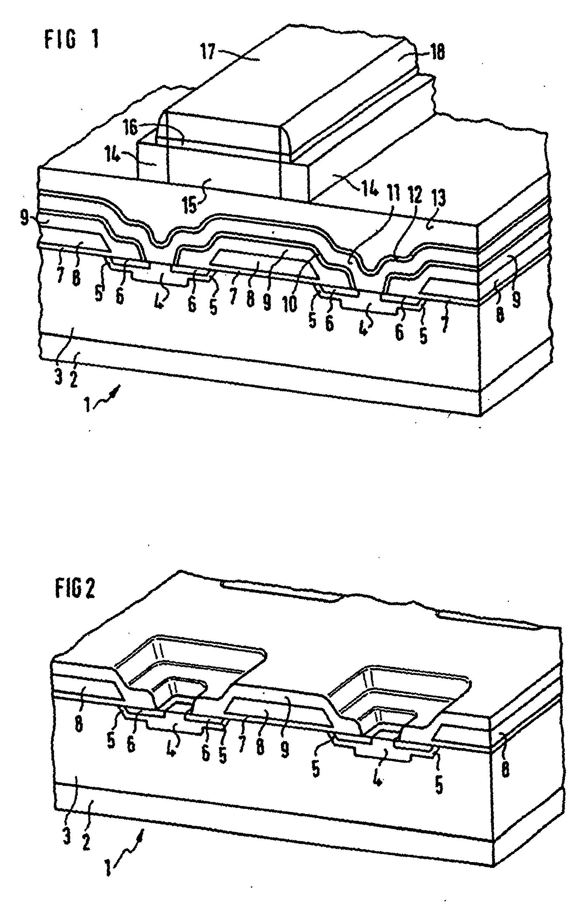

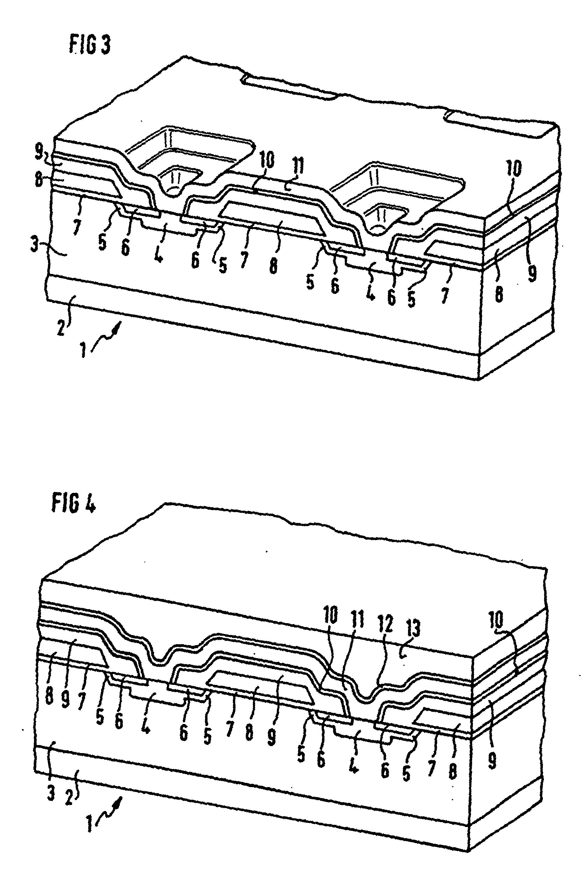

In einem Substrat 1 ist ein Leistungs-MOS-Fet realisiert. Dazu umfaßt das Substrat 1 aus einkristallinem Silizium ein Draingebiet 2, das im Beispiel n⁺-dotiert ist und ein n⁻-dotiertes Gebiet 3, das die Spannungsfestigkeit des Leistungs-MOSFET's bestimmt (siehe Figur 1). An einer dem Draingebiet gegenüberliegenden Hauptfläche des Substrats 1 sind in das n-dotierte Gebiet 3 p-dotierte Gebiete 4 eingelagert, die jeweils Kanalbereiche 5 umfassen, die an die Hauptfläche angrenzen. In den p-dotierten Gebieten 4 sind Sourcegebiete 6 angeordnet, die n⁺-dotiert sind, die an die Hauptfläche so angrenzen, daß die Kanalbereiche 5 jeweils zwischen Sourcegebiet 6 und n⁻-dotiertem Gebiet 3 an die Hauptfläche angrenzen und daß die p-dotierten Gebiete 4 auf der den Kanalbereichen 5 abgewandten Seite der Sourcegebiete 6 ebenfalls an die Hauptfläche angrenzen.

Auf der dem Draingebiet 2 abgewandten Hauptfläche des Substrats 1 ist im Bereich der Kanalbereiche 5 ein Gatedielektrikum 7 angeordnet. Das Gatedielektrikum 7 besteht zum Beispiel aus 80 nm dickem SiO₂. Oberhalb des Gatedielektrikums 7 ist eine Gateelektrode 8 angeordnet, die als zusammenhängende Struktur ausgebildet ist, so daß elektrisch sämtliche Gateelektroden miteinander verbunden sind. Die Gateelektrode 8 besteht zum Beispiel aus p⁺-dotiertem oder n⁻-dotiertem Polysilizium, das eine Dicke von zum Beispiel 500 nm aufweist.

Die Gateelektrode 8 ist vollständig mit einer isolierenden Schicht 9 bedeckt. Die isolierende Schicht 9 besteht zum Beispiel aus SiO₂ und ist so strukturiert, daß im Bereich der dem Draingebiet 2 gegenüberliegenden Hauptfläche die Oberfläche des Sourcegebietes 6 sowie der p-dotierten Gebiete 4 mindestens teilweise freigelegt ist. Die Oberfläche der isolierenden Schicht 9 ist mit einer unteren Passivierungsschicht 10 aus zum Beispiel Titannitrid bedeckt.

Auf der unteren Passivierungsschicht 10 und den teilweise freiliegenden Oberflächen der Sourcegebiete 6 sowie des p-dotierten Gebietes 4 ist eine Source-Metallisierungsebene 11 angeordnet. Die Source-Metallisierungsebene 11 besteht zum Beispiel aus Wolfram oder einem Metallsilizid. Die Source-Metallisierungsebene 11 kontaktiert das Sourcegebiet 6 und die p-dotierten Gebiete 4. Sie verbindet die Sourcegebiete 6 mit den p-dotierten Gebieten 4, die in dem Leistungs-MOS-Fet ein inneres Substrat darstellen. Darüber hinaus verbindet die Source-Metallisierungsebene 11 sämtliche Sourcegebiete 6 und p-dotierten Gebiete 4 miteinander und legt sie auf gleiches Potential.

Die Oberfläche der Source-Metallisierungsebene 11 ist mit einer oberen Passivierungsschicht 12 bedeckt, die zum Beispiel aus Nitrid besteht. Die obere Passivierungsschicht 12 soll Reaktionen zwischen der Source-Metallisierungsebene und SiO₂ vermeiden, die besonders bei Wolfram auftreten.

Auf der oberen Passivierungsschicht 12 ist eine Isolationsschicht 13 angeordnet, die auf der dem Draingebiet 2 abgewandten Oberfläche des Schichtaufbaus eine planare Oberfläche aufweist. Die Isolationsschicht 13 besteht zum Beispiel aus undotiertem SiO₂, aus dotiertem Glas, insbesondere Borphosphorsilikatglas, oder aus einer Kombination aus SiO₂ und Borphosphorsilikatglas. Zur Verbesserung der Oberflächenqualität können an der Oberfläche der Isolationsschicht 13 weitere dielektrische Schichten aus SiO₂ oder Si₃N₄ angeordnet sein (nicht dargestellt).

Auf der planaren Oberfläche der dielektrischen Isolationsschicht 13 ist mindestens ein passives oder aktives Dünnfilmbauelement, zum Beispiel ein Dünnfilmtransistor angeordnet. Der Dünnfilmtransistor umfaßt Source/Draingebiete 14 aus dotiertem Polysilizium und ein Body-Polysilizium 15, das zwischen gegenüberliegenden Source/Draingebieten 14 an der Oberfläche der dielektrischen Isolationsschicht 13 angeordnet ist. Das Body-Polysilizium 15 stellt das interne Substrat des Dünnfilmtransistors dar. Beim Durchschalten des Dünnfilmtransistors bildet sich im Body-Polysilizium 15 ein leitender Kanal aus. An der Oberfläche des Body-Polysiliziums 15 ist ein Gatedielektrikum 16 aus zum Beispiel SiO₂ angeordnet. Auf dem Gatedielektrikum 16 ist eine Gateelektrode 17 aus zum Beispiel dotiertem Polysilizium angeordnet. An dem zur Oberfläche der dielektrischen Isolationsschicht 13 im wesentlichen senkrecht verlaufenden Flanken der Gateelektrode 17 und des Gatedielektrikums 16 sind isolierende Spacer 18 angeordnet. Die isolierenden Spacer 18 bestehen zum Beispiel aus SiO₂.

Der Dünnfilmtransistor ist oberhalb der Source-Metallisierungsebene 11 des Leistungs-MOSFET's angeordnet, wobei die Isolationsschicht 13 zur Isolierung dient. Eine Dünnfilmschaltung hat beim Betrieb des Leistungs-MOSFET's in der Regel eine Spannung in der Nähe des Sourcepotentials. Die Source-Metallisierungsebene 11 schirmt den Dünnfilmtransistor gegen die zum Teil beträchtlichen Spannungsvariationen im Substrat 1 ab und sichert ein ungestörtes Funktionieren des Dünnfilmtransistors.

Da Leistungs-MOSFET's, sowie auch andere Leistungsbauelemente, eine sehr große nutzbare Oberfläche von typisch 0,5 bis 4 cm² aufweisen, kann in der erfindungsgemäßen Schaltungsanordnung oberhalb des Leistungs-MOSFET's auch eine komplexere Dünnfilmschaltung mit einer Vielzahl von Dünnfilmbauelementen wie Transistoren, Dioden, Kondensatoren oder ähnlichem realisiert werden, ohne daß dazu zusätzliche Fläche benötigt würde.

Im folgenden wird die Herstellung der anhand von Figur 1 erläuterten Schaltungsanordnung anhand von Figur 2 bis 4 beschrieben.

Zunächst werden, wie bei der Herstellung eines einzelnen Leistungs-MOSFET's, in einem n⁺-dotierten Substrat 1, das das Draingebiet 2 darstellt, das n⁻-dotierte Gebiet 3, die p-dotierten Gebiete 4, die die Kanalbereiche 5 umfassen, und die n⁺-dotierten Sourcegebiete 6 realisiert (siehe Figur 2). Mindestens im Bereich der Kanalbereiche 5 wird auf der dem Draingebiet 2 gegenüberliegenden Hauptfläche des Substrats 1 das Gatedielektrikum 7 durch zum Beispiel thermische Oxidation erzeugt. Durch Erzeugen einer dotierten Polysiliziumschicht und Strukturieren der dotierten Polysiliziumschicht wird die Gateelektrodenebene 8 gebildet, die eine zusammenhängende Struktur aus dotiertem Polysilizium ist. Die Gateelektrodenebene 8 wird durch die isolierende Schicht 9 vollständig bedeckt, wobei mindestens teilweise die Oberfläche der Sourcegebiete 6 und des p-dotierten Gebietes 4 freiliegen.

Im nächsten Schritt weicht das Herstellungsverfahren von dem für die Herstellung von einzelnen Leistungs-MOSFET üblichen ab. Anstelle der bei Leistungs-MOSFET's üblichen Soure-Metallisierung aus Aluminium wird die Source-Metallisierungsebene 11 aus einem temperaturbeständigen Leiter gebildet. Dazu wird zunächst die Oberfläche der isolierenden Schicht 9 mit der unteren Passivierungsschicht 10 aus zum Beispiel Titannitrid bedeckt. Anschließend wird ganzflächig die Source-Metallisierungsebene 11 zum Beispiel durch CVD-Abscheidung von Wolfram aufgebracht (siehe Figur 3).

Um Reaktionen des Wolframs insbesondere mit SiO₂ zu vermeiden, wird auf die Source-Metallisierungsebene 11 die obere Passivierungsschicht 12 aus zum Beispiel Nitrid aufgebracht (siehe Figur 4).

Zur Bildung der Isolationsschicht 13 wird anschließend zum Beispiel ein relativ dickes Niedertemperatur-SiO₂ in einem Plasmaverfahren oder in einem TEOS-Verfahren ganzflächig in einer Dicke von zum Beispiel 800 nm abgeschieden. Mittels Lack und Rückätzen wird das Niedertemperatur-SiO₂ planarisiert, so daß die dabei entstehende dielektrische Isolationsschicht 13 eine planare Oberfläche aufweist. Anstelle aus undotiertem SiO₂ kann die Isolationsschicht 13 auch aus dotiertem Glas, zum Beispiel Borphosphorsilikatglas mit anschließendem Verfließen bei 900°C, 5 Minuten in Stickstoffatmosphäre oder aus einer Kombination aus SiO₂/Borphosphorsilikatglas und Rückätzen gebildet werden. Die Planarisierung der dielektrischen Isolationsschicht 13 kann auch über ein elektrochemisches Polierverfahren erfolgen. Die Planarisierung ist wichtig, um die durch die vergrabene Gateelektrodenebene 8 erzeugte Topologie einzuebnen.

Auf der planaren Oberfläche der Isolationsschicht 13 erfolgt die Herstellung des oder der Dünnfilmtransistoren. Dazu wird eine Polysiliziumschicht zum Beispiel durch Abscheidung einer 20 bis 200 nm dicken amorphen Siliziumschicht und nachfolgender Rekristallisation und Dotierung gebildet. Durch Strukturierung der Polysiliziumschicht entstehen die Bereiche für die Source/Draingebiete 14 und das Body-Polysilizium 15. Das Gatedielektrikum 16 wird zum Beispiel durch thermische Oxidation oder durch CVD-Abscheidung eine 40 nm dicken SiO₂-Schicht gebildet. Durch Abscheidung einer 200 nm dicken Polysiliziumschicht, die p⁺ oder n⁺-dotiert ist, und anschließender Strukturierung wird die Gateelektrode 17 des Dünnfilmtransistors gebildet. Die Gateelektrode 17 wird durch Reoxidation oder durch CVD-Oxidabscheidung mit den isolierenden Spacern 18 versehen. Schließlich werden die Source/Draingebiete 14 durch entsprechende Dotierung und Aktivierung des Dotierstoffs ausgebildet. Dabei ergibt sich die in Figur 1 dargestellte Struktur.

Nachfolgend wird die Dünnfilmschaltung mit in der Dünnfilmtechnologie üblichen Prozeßschritten planarisiert, mit Aluminium verdrahtet und passiviert. Die elektrische Verbindung zwischen dem Dünnfilmtransistor und dem Leistungs-MOSFET kann zum Beispiel am Rand über ein Kontaktloch, das mit Wolfram aufgefüllt wird und mit einer Aluminiummetallisierung versehen wird, erfolgen. Die Aluminiummetallisierung kann gleichzeitig zur Kontaktverstärkung der Source-Metallisierungsebene des Leistungs-MOSFET's benutzt werden.

In dem Ausführungsbeispiel ist das Draingebiet 2 an einer Oberfläche des Substrats 1, die dem Dünnfilmtransistor abgewandt ist, angrenzend dargestellt. Das Draingebiet 2 kann auch im Substrat 1 angeordnet sein und über eine vergrabene Schicht im Substrat 1 seitlich kontaktiert werden.

## Patentansprüche

1. Integrierte Schaltungsanordnung mit mindestens einem Leistungsbauelement und Niederspannungsbauelementen,
- bei der ein Leistungsbauelement in einem Halbleitersubstrat (1) integriert ist,
- bei der das Leistungsbauelement MOS-gesteuert ist,
- bei der auf einer Hauptfläche des Substrats (1) mindestens ein Kontakt des Leistungsbauelementes angeordnet ist,
- bei der das Leistungsbauelement ein Sourcegebiet (6) aufweist, das an die Hauptfläche angrenzt, und eine Sourcemetallisierungsebene (11), die auf der Hauptfläche angeordnet ist, wobei die Sourcemetallisierungsebene mit dem Sourcegebiet den Kontakt bildet,
- bei der die Sourcemetallisierungsebene (11) mit einer Isolationsschicht (13) bedeckt ist,
- bei der oberhalb des Kontaktes (11) mindestens ein Dünnfilmbauelement (14, 15, 16, 17), das als Niederspannungsbauelement eingesetzt wird, realisiert ist, so daß der Kontakt das Dünnfilmbauelement gegen im Substrat auftretende elektrische Felder abschirmt,
- bei der das Dünnfilmbauelement (14, 15, 16, 17) oberhalb der Sourcemetallisierungsebene (11) angeordnet ist, die durch die Isolationsschicht (13) gegen das Dünnfilmbauelement isoliert ist,
- bei der das Leistungsbauelement eine Zellenstruktur aufweist, wobei mehrere Sourcegebiete (6), die jeweils an einen Kanalbereich (5) angrenzen, an die Hauptfläche angrenzen und wobei die Kanalbereiche (5) ebenfalls an die Hauptfläche angrenzen, auf der Gatedielektrikum (7) und Gateelektrode (8) angeordnet sind,
- bei der die Gateelektroden (8) über eine Gateverbindungsebene miteinander verbunden sind,
- bei der zwischen den Gateelektroden (8) und der Gateverbindungsebene einerseits und der Sourcemetallisierungsebene (11) andererseits eine isolierende Schicht (9) angeordnet ist, die die Gateelektroden (8) und die Gateverbindungsebene von der Sourcemetallisierungsebene (11) isoliert.

2. Schaltungsanordnung nach Anspruch 1,
bei der die durchgehende Sourcemetallisierungsebene aus einem hochtemperaturfesten Leiter gebildet ist.

3. Schaltungsanordnung nach Anspruch 1 oder 2,
bei der die Sourcemetallisierungsebene (11) aus Wolfram oder einem Metallsilizid gebildet ist.

4. Schaltungsanordnung nach einem der Ansprüche 1 bis 3,
bei der die dielektrische Isolationsschicht (13) eine planare Oberfläche aufweist, auf der das oder die Dünnfilmbauelemente (14, 15, 16, 17, 18) angeordnet sind.

5. Schaltungsanordnung nach einem der Ansprüche 1 bis 4,
bei der als Dünnfilmbauelement mindestens ein Dünnfilmtransistor vorgesehen ist.

## Claims

1. Integrated circuit arrangement having at least one power component and low-voltage components,
- in which a power component is realized in a manner integrated in a semiconductor substrate (1),
- in which the power component is MOS-controlled,
- in which at least one contact of the power component is arranged on a main area of the substrate (1),
- in which the power component has a source region (6), which adjoins the main area, and a source metallization plane (11), which is arranged on the main area, the source metallization plane forming the contact with the source region,
- in which the source metallization plane (11) is covered with an insulation layer (13),
- in which at least one thin-film component (14, 15, 16, 17), used as a low-voltage component, is realized above the contact (11), so that the contact screens the thin-film component from electric fields occurring in the substrate,
- in which the thin-film component (14, 15, 16, 17) is arranged above the source metallization plane (11), which is insulated from the thin-film component by the insulation layer (13),
- in which the power component has a cell structure, a plurality of source regions (6), which each adjoin a channel region (5), adjoining the main area, and the channel regions (5) likewise adjoining the main area on which gate dielectric (7) and gate electrode (8) are arranged,
- in which the gate electrodes (8) are connected to one another via a gate connection plane,
- in which an insulating layer (9) is arranged between the gate electrodes (8) and the gate connection plane, on the one hand, and the source metallization plane (11), on the other hand, and insulates the gate electrodes (8) and the gate connection plane from the source metallization plane (11) .

2. Circuit arrangement according to Claim 1,
in which the continuous source metallization plane is formed from a high-temperature-resistant conductor.

3. Circuit arrangement according to Claim 1 or 2,
in which the source metallization plane (11) is formed from tungsten or a metal silicide.

4. Circuit arrangement according to one of Claims 1 to 3,
in which the dielectric insulation layer (13) has a planar surface on which the thin-film component or components (14, 15, 16, 17, 18) is or are arranged.

5. Circuit arrangement according to one of Claims 1 to 4,
in which at least one thin-film transistor is provided as the thin-film component.

## Revendications

1. Ensemble de circuit intégré comprenant au moins un composant de puissance et des composants basse tension,
- un composant de puissance étant intégré dans un substrat à semiconducteur (1),
- le composant de puissance étant commandé par MOS,
- au moins un contact du composant de puissance étant disposé sur une surface principale du substrat (1),
- le composant de puissance présentant une zone source (6) adjacent à la surface principale, ainsi qu'un plan de métallisation source (11) disposé sur la surface principale, le plan de métallisation source établissant le contact avec la zone source,
- le plan de métallisation source (11) étant recouvert par une couche d'isolation (13),
- au-dessus du contact (11) au moins un composant à film mince (14, 15, 16, 17) servant de composant basse tension étant réalisé, de telle sorte que le contact protège le composant à film mince contre des défauts électriques se produisant dans le substrat,
- le composant à film mince (14, 15, 16, 17) étant disposé au-dessus du plan de métallisation source (11), qui est isolé par la couche d'isolation (13) contre le composant à film mince,
- le composant de puissance présentant une structure cellulaire, plusieurs zones source (6) respectivement adjacent à une zone de canaux (5) sont adjacent à la surface principale, et les zones de canaux (5) étant également adjacent à la surface principale, sur laquelle sont disposés le diélectrique de grille (7) et l'électrode de grille (8),
- les électrodes de grille (8) étant reliées l'une à l'autre par un plan de liaison de grilles,
- entre les électrodes de grille (8) et le plan de liaison de grilles d'une part et le plan de métallisation source (11) d'autre part une couche isolante (9) étant disposée, qui isole les électrodes de grille (8) et le plan de liaison de grilles du plan de métallisation source (11).

2. Ensemble de circuit intégré selon la revendication 1, le plan de métallisation source étant formé par un conducteur résistant aux températures élevées.

3. Ensemble de circuit intégré selon la revendication 1 ou 2, le plan de métallisation source (11) étant formé en tungstène ou en silice métallique.

4. Ensemble de circuit intégré selon l'une des revendications 1 à 3, la couche d'isolation diélectrique (13) présentant une surface planaire sur laquelle le ou les composants à film mince (14, 15, 16, 17, 18) sont disposés.

5. Ensemble de circuit intégré selon l'une des revendications 1 à 4, comme composant à film mince au moins un transistor à film mince étant prévu.
